## Europäisches Patentamt
## European Patent Office
## Office européen des brevets

(19)

(11) Veröffentlichungsnummer: **0 071 945**
**B1**

(12) **EUROPÄISCHE PATENTSCHRIFT**

(45) Veröffentlichungstag der Patentschrift:
13.02.85

(51) Int. Cl.⁴: **H 02 M 1/08**

(21) Anmeldenummer: **82106979.6**

(22) Anmeldetag: **02.08.82**

(54) **Zündschaltung für Leistungsthyristoren.**

(30) Priorität: **12.08.81 DE 3131894**

(43) Veröffentlichungstag der Anmeldung:
**16.02.83 Patentblatt 83/7**

(45) Bekanntmachung des Hinweises auf die Patenterteilung:
**13.02.85 Patentblatt 85/7**

(84) Benannte Vertragsstaaten:
**AT BE CH DE FR GB LI SE**

(56) Entgegenhaltungen:
**FR - A - 2 119 931**
**FR - A - 2 443 172**
**GB - A - 2 005 493**
**US - A - 3 567 972**

(73) Patentinhaber: **Siemens Aktiengesellschaft, Berlin und München Wittelsbacherplatz 2, D-8000 München 2 (DE)**

(72) Erfinder: **Thiele, Gerd, Dipl.-Ing., Lessingstrasse 3b, D-8520 Erlangen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft eine Zündschaltung für einen Leistungsthyristor, mit dessen Gate der erste Anschluß mindestens eines ersten überkopfzündfesten Hilfsthyristors verbunden ist, dessen Nullkippspannung kleiner als die Nullkippspannung des Leistungsthyristors ist und der mit Normal-Zündimpulsen gezündet wird.

Eine derartige Zündschaltung ist aus der DE-OS 2 154 283 bekannt. Dabei ist der Anoden-Kathoden-Strecke des Leistungsthyristors die Reihenschaltung einer Überspannungsdetektoreinrichtung und einer Energiespeichereinrichtung parallel geschaltet. Der Verbindungspunkt dieser beiden Einrichtungen ist mit dem Gate des Leistungsthyristors verbunden. Wenn am Leistungsthyristor eine zu hohe Spannung ansteht, so wird die Überspannungsdetektoreinrichtung leitend und liefert ein Triggersignal an das Gate des Leistungsthyristors. Dabei wird der Leistungsthyristor gezündet, bevor die anstehende Spannung einen kritischen Wert erreichen kann. Der von der Überspannungsdetektoreinrichtung gelieferte Gate-Strom steigt zunächst sehr steil an, da die Energiespeichereinrichtung eine Induktivität aufweist, die eine schnelle Stromaufnahme der Energiespeichereinrichtung verhindert. Erst mit einer gewissen Zeitverzögerung wird ein Teil des von der Überspannungsdetektoreinrichtung gelieferten Stroms in die Energiespeichereinrichtung gespeist. Wenn die Spannung am Leistungsthyristor zusammenbricht, dient die Energiespeichereinrichtung als Stromquelle für die Ansteuerung des Leistungsthyristors und hält dadurch ein Triggersignal hinreichender Amplitude und Dauer aufrecht, um ein erfolgreiches Einschalten des Leistungsthyristors sicherzustellen. Die Überspannungsdetektoreinrichtung kann mit einem oder mehreren in Reihe geschalteten Hilfsthyristoren aufgebaut sein. Die Zündimpulse für die Normalzündung können dann den Gattern der Hilfsthyristoren zugeführt sein, so daß auch die Normalzündung über die Hilfsthyristoren erfolgt.

Diese Schaltung eignet sich auch für mehrere, in gleicher Leitrichtung parallel geschaltete Leistungsthyristoren. Wenn jedoch die Thyristoreinrichtung in zwei Stromrichtungen betrieben werden soll, so müssen die Leistungsthyristoren antiparallel geschaltet werden. In diesem Fall wird die bekannte Zündschaltung verhältnismäßig aufwendig, da die gesamte Zündschaltung mit Überspannungsdetektoreinrichtung und Energiespeichereinrichtung doppelt vorgesehen werden muß, d. h. es sind zwei Überspannungsdetektoreinrichtungen und zwei Energiespeichereinrichtungen erforderlich.

Aus der Zeitschrift »Siemens-Energietechnik 2« (1980), Heft 10, S. 420 ist eine Zündschaltung für einen Leistungsthyristor bekannt, mit dessen Gate der erste Anschluß eines Schwellwertelements zur Schutzzündung bei Überspannung verbunden ist. Am zweiten Anschluß des Schwellwertelements, dessen Schwellwertspannung kleiner als die Nullkippspannung des Leistungsthyristors ist, steht die Anodenspannung des Leistungsthyristors an. Dabei wird der Zündbefehl für den Leistungsthyristor in Form von Lichtimpulsen über hochspannungsfeste Lichtleiter vom Erdpotential zum Thyristorpotential übertragen und dort über eine Empfangsschaltung in elektrische Ansteuerimpulse für den Leistungsthyristor umgesetzt. Die zum Zünden des Thyristors erforderliche Energie wird der Anoden-Kathoden-Spannung des Thyristors entnommen. Um den Leistungsthyristor vor Überkopfzünden beim Überschreiten der Nullkippspannung zu schützen, ist zwischen Anode und Gate des Leistungsthyristors eine Breakover-Diode geschaltet. Diese wird beim Überschreiten einer Spannungsschwelle leitend und gibt unabhängig von der Normalansteuerung des Leistungsthyristors einen Ansteuerimpuls ab, der den Leistungsthyristor leitend schaltet und somit die anstehende Spannung zusammenbrechen läßt. Damit wird für positive Überspannungen ein sehr wirksamer Schutz der Leistungsthyristoren erreicht. Außerdem wird bei Serienschaltung mehrerer Leistungsthyristoren in einem Thyristorventil auch die Zuverlässigkeit des Thyristorventils erhöht. Selbst bei defekter Ansteuerelektronik beteiligt sich nämlich der zugehörige Leistungsthyristor ohne unzulässige Überbeanspruchung weiter an der Funktion des Thyristorventils, da er bei Zündung der übrigen Leistungsthyristoren des Thyristorventils durch die dann anstehende Überspannung mitgezündet wird. Bei dieser bekannten Schaltungsanordnung sind getrennte Bauelemente für die Normalzündung und die Schutzzündung bei Überspannung erforderlich.

Aufgabe der Erfindung ist es, eine Zündschaltung der eingangs genannten Art so auszugestalten, daß bei antiparallel geschalteten Leistungsthyristoren die Normalzündung und die Schutzzündung bei Überspannung mit geringem Aufwand erfolgt. Diese Aufgabe wird erfindungsgemäß dadurch gelöst, daß dem Leistungsthyristor mindestens ein weiterer Leistungsthyristor antiparallel geschaltet ist, daß der zweite Anschluß des überkopfzündfesten Hilfsthyristors mit dem Gate des zweiten Leistungsthyristors verbunden ist und daß dem ersten überkopfzündfesten Hilfsthyristor ein zweiter, gleichartiger Hilfsthyristor antiparallel geschaltet ist, der ebenfalls mit Normal-Zündimpulsen gezündet wird.

Über die beiden antiparallel geschalteten Hilfsthyristoren wird der in Leitrichtung liegende Leistungsthyristor gezündet, wenn die an den Hilfsthyristoren anstehende Spannung, d. h. im wesentlichen die Anoden-Kathoden-Spannung des Leistungsthyristors deren Nullkippspannung überschreitet. Damit erfolgt die Zündung des gefährdeten Leistungsthyristors durch die Anoden-Spannung des betreffenden Leistungsthyristors über die Gate-Kathoden-Strecke des zweiten Leistungsthyristors. Als Hilfsthyristor muß ein Thyristortyp ausgewählt werden, bei dem das Überkopfzünden keine Schäden verursacht, d. h. der Hilfsthyristor muß überkopfzündfest sein. Derartige Thyristoren für kleine Leistungen stehen zur Verfügung, während überkopfzündfeste Leistungsthyristoren nicht erhältlich sind. Zusätzlich zur Schutzzündung bei Überspannung erfolgt auch die Normalzündung des jeweils in Leitrichtung liegenden Leistungsthyristors über die Hilfsthyristoren, z. B. indem die Normal-Zündimpulse an dessen Gate gelegt werden. Mit der erfindungsgemäßen Zündschaltung können also bei geringem Aufwand antiparallel geschaltete Leistungsthyristoren im Normalbetrieb gezündet und gleichzeitig gegen Überspannung geschützt werden.

Alternativ kann dem Leistungsthyristor ein weiterer Leistungsthyristor antiparallel geschaltet sein, wobei mit den Gates der beiden Leistungsthyristoren eine Gleichrichter-Brückenschaltung eingangsseitig verbunden ist und der Hilfsthyristor an den Ausgängen der Gleichrichter-Brückenschaltung liegt. Diese Zündschaltung entspricht in ihrer Wirkungsweise der bereits erläuterten Zündschaltung. Es ist jedoch nur ein Hilfsthyristor erforderlich, da dieser über die Gleichrichter-Brückenschaltung stets in Leitrichtung beaufschlagt wird.

Anstelle von zwei antiparallel geschalteten Hilfsthyristoren kann auch ein Triac verwendet werden.

Bei Zündschaltungen für zwei antiparallel geschaltete Leistungsthyristoren kann der Gate-Kathoden-Strecke jedes Leistungsthyristors eine Diode antiparallel geschaltet sein. Damit fließt der Zündstrom nicht in Rückwärtsrichtung über die Gate-Kathoden-Strecke des jeweils antiparallel geschalteten Leistungsthyristors, sondern über die antiparallel geschaltete Diode.

Es können mehrere Hilfsthyristoren in Serie geschaltete sein. Dabei summieren sich die Nullkippspannungen der einzelnen Hilfsthyristoren zu einer gemeinsamen Nullkippspannung, die durch die Anzahl der in Serie geschalteten Hilfsthyristoren festgelegt werden kann.

Zweckmäßigerweise ist dabei jedem Hilfsthyristor ein Widerstand parallel geschaltet. Mit diesen Widerständen wird die Spannungsaufteilung in der Reihenschaltung der Hilfsthyristoren gesteuert.

Zweckmäßigerweise wird jeder Hilfsthyristor mit Lichtimpulsen als Normal-Zündimpulse angesteuert. Bei einer derartigen direkten Ansteuerung der Hilfsthyristoren durch Lichtimpulse wird der schaltungsmäßige Aufwand für die Zündschaltung äußerst gering. Sowohl zur Schutzzündung als auch zur Normalzündung der antiparallel gesteuerten Leistungsthyristoren sind nur wenige Hilfsthyristoren erforderlich.

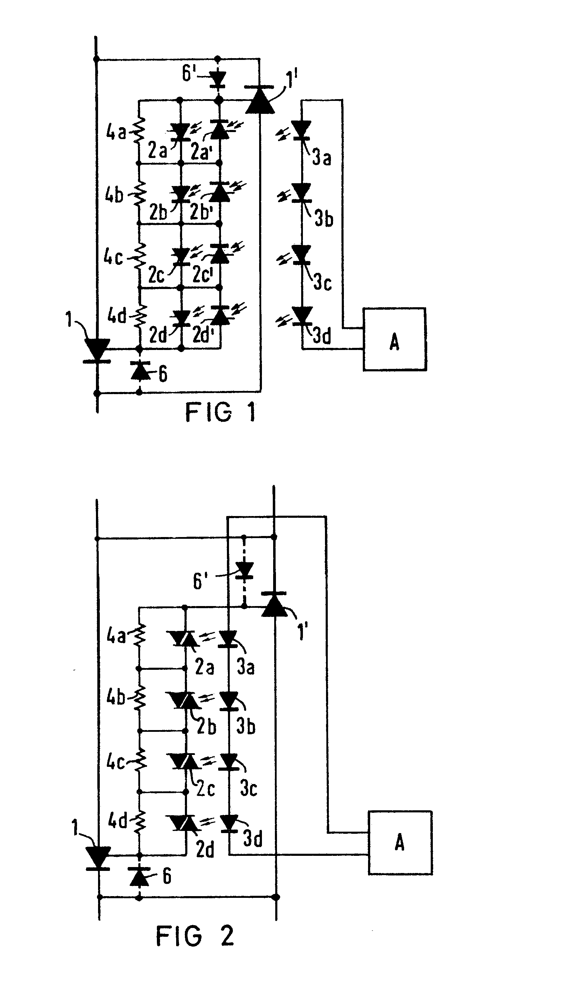

Die erfindungsgemäße Zündschaltung wird nachfolgend beispielhaft anhand der Fig. 1 bis 3 näher erläutert.

Fig. 1 zeigt eine Zündschaltung für zwei antiparallel geschaltete Leistungsthyristoren 1, 1'.

Dabei ist zwischen den Gates der beiden Leistungsthyristoren 1, 1' eine Reihenschaltung von jeweils paarweise antiparallel geschalteten Hilfsthyristoren 2a, 2a' bis 2d, 2d' angeordnet. Jedem antiparallel geschalteten Paar von Hilfsthyristoren 2a, 2a' bis 2d, 2d' ist ein Widerstand 4a bis 4d parallel geschaltet. Da die Gate-Kathoden-Spannungen der Leistungsthyristoren 1 und 1' praktisch vernachlässigbar sind, steht an der Reihenschaltung der paarweise antiparallel geschalteten Hilfsthyristoren 2a, 2a' bis 2d, 2d' im wesentlichen die Anoden-Kathoden-Spannung der Leistungsthyristoren 1, 1' an. Diese Spannung verteilt sich, gesteuert durch die Widerstände 4a bis 4d auf die einzelnen Paare von Hilfsthyristoren 2a, 2a' bis 2d, 2d'. Die Widerstände 4a bis 4d sind hochohmig, so daß der durch sie fließende Strom nicht zur Zündung des Leistungsthyristors 1 ausreicht. Sobald die an der Antiparallelschaltung der Leistungsthyristoren 1, 1' anstehende Spannung die Summe der Nullkippspannungen der Hilfsthyristoren 2a bis 2d bzw. 2a' bis 2d' in beliebiger Richtung überschreitet, zünden die in Durchlaßrichtung liegenden Hilfsthyristoren über Kopf. Damit fließt je nach Spannungsrichtung ein Zündstrom entweder über die Kathoden-Gate-Strecke des Leistungsthyristors 1' und die Reihenschaltung der Hilfsthyristoren 2a bis 2d in das Gate des Leistungsthyristors 1 oder über die Gate-Kathoden-Strecke des Leistungsthyristors 1 und die Reihenschaltung der Hilfsthyristoren 2a' bis 2d' in das Gate des Leistungsthyristors 1'. Damit wird ein Zündimpuls auf das Gate des in Durchlaßrichtung liegenden Leistungsthyristors 1 oder 1' geschaltet, der diesen in den leitenden Zustand bringt.

Bei einem derartigen Zündvorgang wird die Gate-Kathoden-Strecke des Leistungsthyristors 1' bzw. 1 vom Zündstrom in Sperrichtung durchflossen. Dies ist bei einem Spannungsabfall von wenigen Volt möglich, da die Sperrfähigkeit der Gate-Kathoden-Strecke sehr gering ist. Der in den Datenblättern der Thyristoren angegebene zulässige Sperrstrom der Gate-Kathoden-Strecke reicht im allgemeinen als Zündstrom ohne weiteres aus. Alternativ kann jedoch, wie in Fig. 1 gestrichelt eingezeichnet, antiparallel zur Gate-Kathoden-Strecke jedes Leistungsthyristors 1, 1' eine Diode 6, 6' geschaltet sein. Damit fließt der Zündstrom nicht in Sperrichtung über die jeweilige Gate-Kathoden-Strecke des Leistungsthyristors 1, 1', sondern über die antiparallel geschaltete Diode 6 bzw. 6'.

Die beschriebene Schaltung ist so ausgelegt, daß die Summe der Nullkippspannungen der Thyristoren 2a bis 2d bzw. 2a' bis 2d' kleiner ist als die Nullkippspannung der Leistungsthyristoren 1 bzw. 1'. Damit ist sichergestellt, daß die Anoden-Kathoden-Spannung der Leistungsthyristoren 1, 1' nicht über deren Nullkippspannung steigen kann, so daß ein Überkopfzünden sicher vermieden wird. Ein derartiges Überkopfzünden könnte nämlich zu Beschädigungen der Leistungsthyristoren 1, 1' führen. Dagegen sind für die Thyristoren kleinerer Leistung, also die Hilfsthyristoren 2a bis 2d und 2a' bis 2d' Typen verfügbar, die Überkopfzündungen ohne Beschädigungen überstehen.

Die Normal-Zündung der Leistungsthyristoren 1, 1' erfolgt ebenfalls durch Zündung der Hilfsthyristoren 2a bis 2d bzw. 2a' bis 2d', jedoch nicht durch Überkopfzündung, sondern durch einen Zündimpuls auf das Gate bzw. durch Lichtzündung. Beim Ausführungsbeispiel nach Fig. 1 sind die Hilfsthyristoren 2a bis 2d und 2a' bis 2d' optogekoppelte Thyristoren, deren Leuchtdioden 3a bis 3d in Serie geschaltet sind und von einer Ansteuereinrichtung A angesteuert werden. Damit wird eine galvanische Trennung zu den Hilfsthyristoren 2a bis 2d und 2a' bis 2d' erreicht.

Die Schaltung nach Fig. 2 entspricht im wesentlichen der Schaltung nach Fig. 1, wobei lediglich jedes Paar antiparallel geschalteter Hilfsthyristoren 2a, 2a' bis 2d, 2d' durch einen Triac 2a bis 2d ersetzt ist. Die Triacs 2a bis 2d sind optogekoppelte Ausführungen, wobei die zugeordneten Leuchtdioden 3a bis 3d wie bei der Zündschaltung nach Fig. 1 von einer Ansteuerschaltung A angesteuert werden.

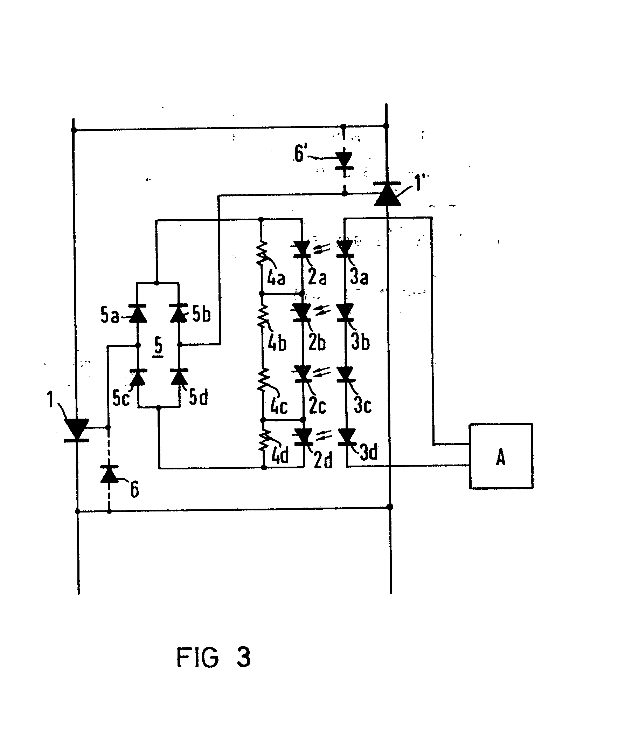

Fig. 3 zeigt eine weiteres Schaltungsbeispiel zur Zündung zweier antiparallel geschalteter Leistungsthyristoren 1 und 1'. Dabei sind die Gates der Leistungsthyristoren 1 und 1' jeweils mit den Eingängen einer Gleichrichter-Brückenschaltung 5 verbunden, an deren Ausgängen die Reihenschaltung der Hilfsthyristoren 2a bis 2d liegt. Über die Gleichrichter-Brückenschaltung 5 wird die Spannung zwischen den Gates der Leistungsthyristoren 1 und 1', die, wie bereits dargelegt, im wesentlichen mit der Anoden-Kathoden-Spannung übereinstimmt, den Hilfsthyristoren 2a bis 2d stets mit derselben Polarität zugeführt. Wenn diese bei Überspannung zünden, so fließt über die Gleichrichter-Brücke 5 und die Hilfsthyristoren 2a bis 2d ein Zündstrom vom Gate des in Sperrrichtung beaufschlagten Leistungsthyristors 1 bzw. 1' in das Gate des in Leitrichtung beanspruchten Leistungsthyristors 1 bzw. 1'. Wenn beispielsweise am Leistungsthyristor 1 eine Überspannung in Leitrichtung ansteht, so fließt ein Zündstrom von der Anode des Leistungsthyristors 1 über die in Sperrrichtung liegende Kathoden-Gate-Strecke des Leistungsthyristors 1' bzw. die dazu antiparallel liegende, gestrichelt eingezeichnete Diode 6', die Diode 5b der Gleichrichter-Brücke 5, die Hilfsthyristoren 2a bis 2d und die Diode 5c der Gleichrichter-Brücke 5 in das Gate des Leistungsthyristors 1. Dieser wird damit gezündet, so daß die Überspannung zusammenbricht. Wie bei den Ausführungsbeispielen nach den Fig. 1 und 2 werden die Hilfsthyristoren 2a bis 2d im Normalfall durch Lichtansteuerung gezündet.

## Patentansprüche

1. Zündschaltung für einen Leistungsthyristor (1), mit dessen Gate der erste Anschluß mindestens eines ersten überkopfzündfesten Hilfsthyristors (2a—2d, 2a'—2d') verbunden ist, dessen Nullkippspannung kleiner als die Nullkippspannung des Leistungsthyristors ist und der mit Normal-Zündimpulsen gezündet wird, dadurch gekennzeichnet, daß dem Leistungsthyristor (1) mindestens ein weiterer Leistungsthyristor (1') antiparallel geschaltet ist, daß der zweite Anschluß des überkopfzündfesten Hilfsthyristors (2a) mit dem Gate des zweiten Leistungsthyristors (1') verbunden ist und daß dem ersten überkopfzündfesten Hilfsthyristor (2a) ein zweiter gleichartiger Hilfsthyristor (2a') antiparallel geschaltet ist, der ebenfalls mit Normal-Zündimpulsen gezündet wird.

2. Zündschaltung für einen Leistungsthyristor, mit dessen Gate der erste Anschluß mindestens eines überkopfzündfesten Hilfsthyristors verbunden ist, dessen Nullkippspannung kleiner als die Nullkippspannung des Leistungsthyristors ist und der mit Normal-Zündimpulsen gezündet wird, dadurch gekennzeichnet, daß dem Leistungsthyristor (1) ein weiterer Leistungsthyristor (1') antiparallel geschaltet ist, daß mit den Gates der beiden Leistungsthyristoren (1, 1') eine Gleichrichter-Brückenschaltung (5) eingangsseitig verbunden ist und daß der Hilfsthyristor (2a bis 2d) an den Ausgängen der Gleichrichter-Brückenschaltung (5) liegt.

3. Zündschaltung nach Anspruch 1, dadurch gekennzeichnet, daß anstelle der zwei antiparallel geschalteten Hilfsthyristoren (2a, 2a' bis 2d, 2d') ein Triac (2a bis 2d) verwendet wird.

4. Zündschaltung nach einem der Ansprüche 1 bis 3, dadurch gekennzeichnet, daß der Gate-Kathoden-Strecke jedes Leistungsthyristors (1, 1') eine Diode (6, 6') antiparallel geschaltet ist.

5. Zündschaltung nach einem der Ansprüche 1 bis 4, dadurch gekennzeichnet, daß mehrere Hilfsthyristoren (2a bis 2d, 2a' bis 2d') in Serie geschaltet sind.

6. Zündschaltung nach Anspruch 5, dadurch gekennzeichnet, daß jedem Hilfsthyristor (2a bis 2d) ein Widerstand (4a bis 4d) parallel geschaltet ist.

7. Zündschaltung nach einem der Ansprüche 1 bis 6, dadurch gekennzeichnet, daß jeder Hilfsthyristor (2a bis 2d, 2a' bis 2d') mit Lichtimpulsen als Normal-Zündimpulse angesteuert wird.

## Claims

1. An ignition circuit for a power thyristor (1) whose gate is connected to the first terminal of at least one first auxiliary thyristor (2a—2d, 2a'—2d') which is overhead-ignition-resistant and whose zero trigger voltage is lower than the zero trigger voltage of the power thyristor and which is ignited by normal ignition pulses, characterised in that at least one further power thyristor (1') is connected to the power thyristor (1) in antiparallel fashion, that the second terminal of the overhead-ignitionresistant auxiliary thyristor (2a) ist connected to the gate of the second power thyristor (1'), and that the first overhead-ignitionresistant auxiliary thyristor (2a) ist connected in antiparallel fashion with a second identical auxiliary thyristor (2a') which is likewise ignited by normal ignition pulses.

2. An ignition circuit for a power thyristor whose gate is connected to the first terminal of at least one overhead-ignitionresistant auxiliary thyristor whose zero trigger voltage is lower than the zero trigger voltage of the power thyristor and which is ignited by normal ignition pulses, characterised in that a further power thyristor (1') is connected to the power thyristor (1), in antiparallel fashion, that a rectifier-bridge circuit (5) is connected at the input end to the gates of the two power thyristors (1, 1'), and that the auxiliary thyristor (2a to 2d) is connected to the outputs of the rectifier-bridge circuit (5).

3. An ignition circuit as claimed in claim 1, characterised in that a triac (2a to 2d) is used in place of the two auxiliary thyristors (2a, 2a' to 2d, 2d') connected in antiparallel fashion.

4. An ignition circuit as claimed in one of claims 1 to 3, characterised in that a diode (6, 6') is connected to the gate-cathode path of each power thyristor (1, 1') in antiparallel fashion.

5. An ignition circuit as claimed in one of claims 1 to 4, characterised in that a plurality of auxiliary thyristors (2a to 2d, 2a' to 2d') are connected in series.

6. An ignition circuit as claimed in claim 5, characterised in that a resistor (4a to 4d) is connected in parallel with each auxiliary thyristor (2a to 2d).

7. An ignition circuit as claimed in one of claims 1 to 6, characterised in that each auxiliary thyristor (2a to 2d, 2a' to 2d') is driven by light pulses as normal ignition pulses.

**Revendications**

1. Circuit d'amorçage pour un thyristor de puissance (1), à la grille duquel est raccordée la première borne d'au moins un premier thyristor auxiliaire (2a—2d, 2a'—2d') résistant à un amorçage au-dessus de la tête et dont la tension de retournement est inférieure à la tension de retournement du thyristor de puissance et qui est amorcé par des impulsions normales d'amorçage, caractérisé par le fait qu'au thyristor de puissance (1) se trouve relié selon un montage antiparallèle, au moins un autre thyristor de puissance (1'), que la seconde borne du thyristor auxiliaire de puissance (2a) résistant à un amorçage au-dessus de la tête, est reliée à la grille du second thyristor de puissance (1'), et qu'au premier thyristor auxiliaire (2a) résistant à un amorçage au-dessus de la tête se trouve relié selon un montage antiparallèle, un second thyristor auxiliaire (2a') identique, qui est également amorcé par des impulsions normales d'amorçage.

2. Circuit d'amorçage pour un thyristor de puissance, à la grille duquel est raccordée la première borne d'au moins un premier thyristor auxiliaire résistant à un amorçage par la tête et dont la tension de retournement est inférieure à la tension de retournement du thyristor de puissance et qui est amorcé par des impulsions normales d'amorçage, caractérisé par le fait qu'au thyristor de puissance (1) se trouve, relié, selon un montage antiparallèle, un autre thyristor de puissance (1'), qu'un circuit redresseur en pont (5) est relié du côté entrée à la grille des deux thyristors de puissance (1, 1') et que le thyristor auxiliaire (2a—2d) est relié aux sorties du circuit redresseur en pont (5).

3. Circuit d'amorçage suivant la revendication 1, caractérisé par le fait qu'on utilise un triac (2a—2d) à la place des deux thyristors auxiliaires (2a, 2a' à 2d, 2d') reliés selon un montage antiparallèle.

4. Circuit d'amorçage suivant une des revendications 1 à 3, caractérisé par le fait qu'une diode (6, 6') est reliée selon un montage antiparallèle à la voie grille-cathode de chaque thyristor de puissance (1, 1').

5. Circuit d'amorçage suivant l'une des revendications 1 à 4, caractérisé par le fait que plusieurs thyristors auxiliaires (2a à 2d, 2a' à 2d'), sont branchés en série.

6. Circuit d'amorçage selon la revendication 5, caractérisé par le fait qu'une résistance (4a à 4d) est branchée en parallèle avec chaque thyristor auxiliaire (2a à 2d).

7. Circuit d'amorçage suivant l'une des revendications 1 à 6, caractérisé par le fait que chaque thyristor auxiliaire (2a à 2d, 2a' à 2d') est commandé par des impulsions lumineuses servant d'impulsions normales d'amorçage.

FIG 1

FIG 2

FIG 3